## Europäisches Patentamt
## European Patent Office
## Office européen des brevets

(19)

(11) Veröffentlichungsnummer: **0 047 458**
**B1**

(12) **EUROPÄISCHE PATENTSCHRIFT**

(45) Veröffentlichungstag der Patentschrift:
02.05.85

(51) Int. Cl.⁴: **G 03 F 7/26, B 65 H 5/10**

(21) Anmeldenummer: **81106761.0**

(22) Anmeldetag: **29.08.81**

(54) Vorrichtung zum Anheben, Greifen und Transportieren von Druckplatten.

(30) Priorität: **08.09.80 DE 3033706**

(43) Veröffentlichungstag der Anmeldung:
**17.03.82 Patentblatt 82/11**

(45) Bekanntmachung des Hinweises auf die Patenterteilung:
**02.05.85 Patentblatt 85/18**

(84) Benannte Vertragsstaaten:
**BE DE FR GB IT NL**

(56) Entgegenhaltungen:
**DE - A - 1 815 981**
**DE - A - 2 102 442**
**DE - B - 1 260 957**
**GB - A - 417 826**

(73) Patentinhaber: **HOECHST AKTIENGESELLSCHAFT,
Postfach 80 03 20, D-6230 Frankfurt am Main 80 (DE)**

(72) Erfinder: **Dennhardt, Werner, Kellerskopfstrasse 32,
D-6204 Taunusstein 2 (DE)**
Erfinder: **Heist, Hans, Frankenwaldstrasse 7,
D-6200 Wiesbaden-Delkenheim (DE)**

ACTORUM AG

## Beschreibung

Die Erfindung betrifft eine Vorrichtung zum Anheben, Greifen und Transportieren von Druckplatten in einem Verarbeitungsgerät, in dem Druckplatten in der jeweiligen Verarbeitungsstation während der Verarbeitung in angesaugter Stellung auf einem Verarbeitungstisch gehalten werden, mit einer unterhalb des Verarbeitungstisches angeordneten, fest mit dem Verarbeitungstisch verbundenen Anhebeeinrichtung für die Druckplatten, die an ihrem oberen Ende mindestens einen Bolzen aufweist.

Aus der DE-A1-1 815 981 ist eine Vorrichtung bekannt, die die einzelne Druckplatte während der Verarbeitung in angesaugter Stellung auf einem Verarbeitungstisch festhält. Unterhalb des Verarbeitungstisches sind Auswerferfinger angeordnet, die mechanisch oder elektromagnetisch durch zugehörige Durchführungen des Verarbeitungstisches hindurch angehoben werden, um die Druckplatte von dem Verarbeitungstisch abzuheben. Dieser Verarbeitungstisch ist ortsfest und nicht in Längsrichtung verfahrbar, so dass ein automatischer Transport der Druckplatte zu einer weiteren Verarbeitungsstation nicht möglich ist.

Die Vorrichtung der eingangs beschriebenen Art ist insbesondere für Verarbeitungsanlagen geeignet, in denen beschriftete und bebilderte Druckplatten, die direkt zum Drucken geeignet sind und in einer Weise hergestellt werden, bei der die Druckplatte elektrostatisch aufgeladen, eine Vorlage bildmässig auf die Druckplatte projiziert und diese dann entwickelt, fixiert und entschichtet wird. Zur Durchführung dieser Verarbeitungsschritte durchläuft die Druckplatte die jeweiligen Verarbeitungsstationen. In einzelnen Stationen, wie z.B. der Belichtungs- oder Entwicklungsstation, liegt die Druckplatte auf einem Verarbeitungstisch, der eine Kammer bildet und an seiner Oberseite eine Anzahl von Löchern aufweist. Die Kammer ist über eine Saugleitung mit einer Vakuumpumpe verbunden. Dadurch wird die auf dem Verarbeitungstisch liegende Druckplatte durch Erzeugen eines Vakuums während der Verarbeitung auf dem Tisch festgehalten. Nach Beendigung des jeweiligen Verarbeitungsschrittes wird belüftet, die Druckplatte angehoben, von einer Greifereinrichtung erfasst und zur nächsten Verarbeitungsstation transportiert.

Zum Anheben der Druckplatte wird im allgemeinen eine unterhalb des Verarbeitungstisches angeordnete Anhebeeinrichtung verwendet, bei der nach der Belüftung ein Bolzen mittels eines Antriebsmittels angehoben wird, der wiederum die Platte von dem Verarbeitungstisch abhebt. Bevor die nächste Druckplatte auf den Verarbeitungstisch transportiert wird, wird der Bolzen wieder gesenkt. Durch die Verwendung eines Antriebsmittels, das entsprechend gesteuert werden muss, ist diese Vorrichtung sehr aufwendig. Ausserdem besteht die Gefahr, dass bei einer Störung der Bolzen überhaupt nicht oder nicht rechtzeitig gesenkt wird, so dass Beschädigungen der Druckplatte auftreten können.

Zum Greifen und Transportieren der angehobenen Platte wird eine oberhalb des Verarbeitungstisches in Längsrichtung der Anlage hin und her fahrbare Greifereinrichtung verwendet. Das Greiferteil dieser Einrichtung hat die Form einer Wäscheklammer. Wenn sie in Richtung des angehobenen Endes der Druckplatte gefahren wird, wird die Klammer mit Hilfe eines Motors geöffnet. Wenn sich das Druckplattenende zwischen den geöffneten Klammerenden befindet, wird die Klammer geschlossen und die Einrichtung mit der gefassten Druckplatte zur nächsten Verarbeitungsstation gefahren. An der Stelle, wo die Druckplatte abgelegt werden soll, wird die Klammer wieder geöffnet. Diese Greifereinrichtung benötigt eine aufwendige Justage. Zum Öffnen der Klammer ist ein Antriebsmittel notwendig, das entsprechend gesteuert werden muss.

Aufgabe der vorliegenden Erfindung ist es, eine Vorrichtung der eingangs genannten Art so zu verbessern, dass kein Antriebsmittel zum Anheben der Druckplatte notwendig ist, und Beschädigungen der Druckplatte durch die Anhebevorrichtung ausgeschlossen sind.

Diese Aufgabe wird erfindungsgemäss dadurch gelöst, dass sich oberhalb des Verarbeitungstisches eine in Längsrichtung des Geräts hin und her fahrbare Greifereinrichtung befindet, die die angehobene Druckplatte greift und weitertransportiert, dass der Verarbeitungstisch zusammen mit der Anhebeeinrichtung in Längsrichtung des Geräts verschiebbar ist, dass für die Anhebeeinrichtung eine in Transportrichtung der Druckplatte schräg ansteigende Lauffläche vorgesehen ist, deren Abstand zur auf dem Verarbeitungstisch angesaugten Druckplatte am Beginn der Steigung grösser und am Ende der Steigung kleiner ist als die Höhe der Anhebeeinrichtung im freien Zustand, und dass mindestens der eine Bolzen der bei auf ihn ausgeübtem Druck in die Anhebeeinrichtung hinein verschiebbar ist und dabei mindestens eine Feder in der Anhebeeinrichtung vorspannt, deren Federkraft zum Anheben der Druckplatte ausreicht, wenn der Verarbeitungstisch belüftet ist, jedoch nicht ausreicht, die auf dem Verarbeitungstisch angesaugte Druckplatte durch den Bolzen zu beschädigen.

Die weitere Ausgestaltung der Erfindung ergibt sich durch die Merkmale der Ansprüche 2 bis 6.

Durch die in Transportrichtung der Druckplatte schräg ansteigende Lauffläche für die Anhebeeinrichtung, die mit einem in die Abhebevorrichtung gegen eine Feder verschiebbaren Bolzen versehen ist, erübrigt sich ein Antriebsmittel zum Anheben der Druckplatte. Durch die Lauffläche wird ferner sichergestellt, dass beim Rücklauf der Anhebevorrichtung der Bolzen auf ein Niveau gesenkt wird, auf dem Beschädigungen ausgeschlossen sind.

Die Greifereinrichtung weist als wesentliche Teile eine Auflage für die Druckplatte sowie einen Klemmwinkel auf, der in seinem Scheitel drehbar gelagert ist und mit seinem einen Ende auf der Auflage für die Druckplatte aufliegt. Der Klemmschenkel des Klemmwinkels ist in Richtung der zu greifenden Druckplatte geneigt. Dadurch wird ein leichtes Einschieben des Druckplattenendes zwischen Auflage und Klemmschenkel gewährleistet, wenn die Greifereinrichtung in Richtung Druckplatte bewegt wird. Der Klemmschenkel und die eingeschobene Druckplatte schliessen zwischen sich einen Winkel von 90° − $\alpha$ ein. Der Winkel $\alpha$ ist gleich oder kleiner als ein Grenzwinkel $\alpha_o$, bei dem das Gewicht des Klemmwinkels gerade noch eine genügende Normalkraft auf die Druckplatte und damit eine genügende Reibungskraft hervorruft, um die Druckplatte bei der Bewegung der Greifereinrichtung mitzunehmen.

Wenn die Bewegung der Greifereinrichtung in Transportrichtung einsetzt, tritt für einen Augenblick eine Relativbewegung zwischen Druckplatte und Greifereinrichtung ein, wodurch der Klemmwinkel um einen kleinen Betrag im Uhrzeigersinn gedreht wird. Durch diese Drehung wird die Druckplatte zwischen Auflage und Klemmschenkel eingeklemmt, dadurch die Relativbewegung gestoppt und die Druckplatte mit der Greifereinrichtung in Transportrichtung bewegt. Die oben genannte Bedingung, den Winkel nicht grösser als den Grenzwinkel $\alpha_o$ zu wählen, stellt sicher, dass ausreichend Reibung zwischen Druckplatte und Greifereinrichtung auftritt, um den Klemmwinkel in die Klemmstellung zu bringen und zu verhindern, dass die Druckplatte aus der Greifereinrichtung herausrutscht.

Wenn die Klemmwirkung eingesetzt hat, kann die Druckplatte nur durch eine Drehung des Klemmschenkels entgegen dem Uhrzeigersinn wieder freigegeben werden. Daher ist an der Stelle in der Bewegungsbahn der Greifereinrichtung, wo die Druckplatte freigegeben werden soll, eine Auflaufschräge für das andere Ende des Klemmwinkels angeordnet. Wenn dieses Ende auf die Auflaufschräge kommt, wird es angehoben und damit der Klemmwinkel um seine Achse entgegen dem Uhrzeigersinn gedreht, wodurch die Druckplatte freigegeben wird und aus der Greifereinrichtung fällt.

Bei dieser Greifereinrichtung sind keine Antriebsmittel zum Öffnen der Greifereinrichtung während der Druckplatteneinführung und -freigabe notwendig. Dennoch wird die Druckplatte sicher festgehalten und kann zur nächsten Verarbeitungsstation transportiert werden.

Die Erfindung wird im folgenden anhand der Zeichnung näher erläutert. Es zeigen:

Fig. 1 einen Längsschnitt durch die Vorrichtung mit angesaugter Druckplatte,

Fig. 2 einen Längsschnitt durch die Vorrichtung mit angehobener und in die Greifereinrichtung geschobener Druckplatte und

Fig. 3 ein Diagramm, das die in der Greifereinrichtung wirkenden Kräfte zur Bestimmung des Grenzwinkels $\alpha_o$ zeigt.

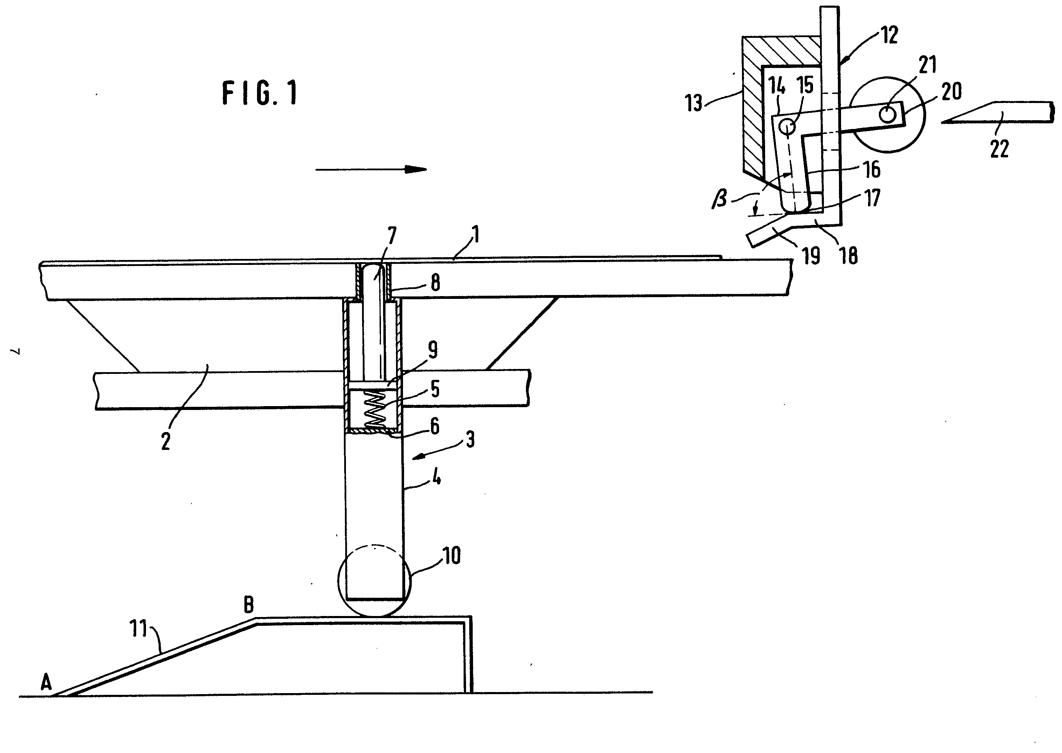

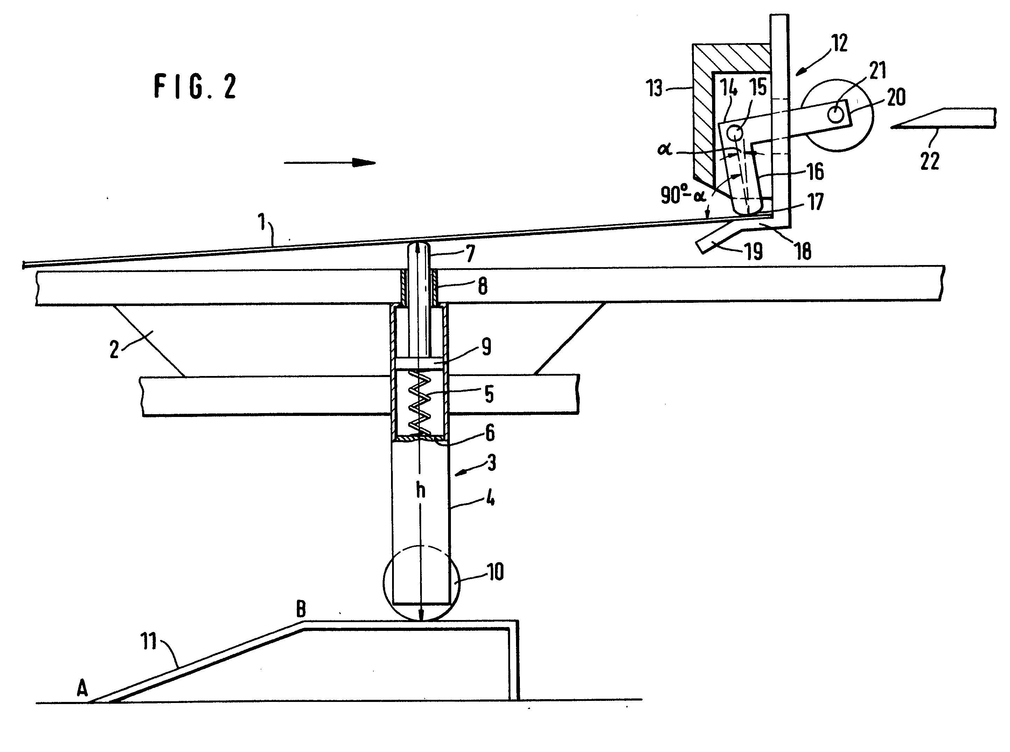

Im folgenden wird die Vorrichtung am Beispiel der Entwicklungsstation beschrieben. In Fig. 1 liegt die Druckplatte 1 auf dem Entwicklungstisch 2, an den ein Vakuum gelegt ist, so dass sie auf dem Entwicklungstisch 2 festgehalten wird. Die Anhebeeinrichtung 3 ist mit dem Entwicklungstisch 2 fest verbunden und kann daher von einem nicht gezeigten Antriebsmechanismus für den Entwicklungstisch 2 zusammen mit diesem in Längsrichtung der Anlage hin und her gefahren werden. Die Anhebeeinrichtung 3 weist in einem Gehäuse 4 eine Feder 5 auf, die auf einem Gegenlager 6 abgestützt ist. Die Federkraft ist so gewählt, dass sie ausreicht, die Druckplatte 1 anzuheben, wenn der Entwicklungstisch 2 belüftet wird, jedoch nicht so stark ist, dass die angesaugte Druckplatte 1 durch die Bolzen 7 beschädigt wird. Am oberen Ende der Anhebeeinrichtung 3 befinden sich zwei Bolzen 7, für die Führungshülsen 8 vorgesehen sind. Die Bolzen 7 sind auf einer Schiene 9 befestigt, die parallel zur Druckplattenbreite in der Anhebeeinrichtung angeordnet ist und auf der Feder 5 aufliegt. Wenn Druck auf die Bolzen 7 ausgeübt wird, werden sie in die Anhebeeinrichtung 3 geschoben und mit ihnen die Schiene 9 unten verschoben, wodurch die Feder 5 gespannt wird. Diese Stellung ist in Fig. 1 dargestellt, während Fig. 2 die entspannte Stellung zeigt. Am Fuss der Anhebeeinrichtung 3 sind Rollen 10, auf denen die Anhebeeinrichtung 3 bei einer Bewegung des Entwicklungstisches 2 in Längsrichtung der Anlage über die in Transportrichtung der Druckplatte 1 (vgl. Pfeil) schräg ansteigende Lauffläche 11 rollen kann. Der Abstand der Lauffläche 11 zur auf dem Entwicklungstisch 2 angesaugten Druckplatte 1 ist am Beginn der Steigung (A) grösser und am Ende der Steigung (B) kleiner als die Höhe h der Anhebeeinrichtung 3, die sie im entspannten Zustand hat, d.h. wenn auf die Bolzen 7 kein Druck ausgeübt wird.

Der Entwicklungstisch 2 mit der angesaugten Druckplatte 1 befindet sich zunächst in einer Stellung, die gegenüber der in Fig. 1 gezeigten Stellung nach links verschoben ist. Die Anhebeeinrichtung 3 befindet sich dann vor der schräg ansteigenden Lauffläche 11, d.h. im entspannten Zustand. Wenn der Entwicklungstisch 2 in Transportrichtung der Druckplatte (vgl. Pfeil) verschoben wird, rollt die Anhebeeinrichtung 3 die Lauffläche 11 hinauf. Die angesaugte Druckplatte 1 drückt nun gegen die Bolzen 7, die mit der Schiene 9 nach unten gedrückt werden und die Feder 5 vorspannen (vgl. Fig. 1). Wenn der Entwicklungstisch 2 belüftet wird, drückt die Feder 5 die Schiene 9 mit den Bolzen 7 nach oben, die die Druckplatte 1 in die in Fig. 2 gezeigte Stellung anheben. Danach wird die Greifereinrichtung 12, die sich bis jetzt in einer Stellung ausserhalb des Druckplattenbereiches befand (vgl. Fig. 1), mittels eines nicht dargestellten Antriebsmittels in Richtung Druckplatte 1 verschoben, bis das Druckplattenende in die Greifereinrichtung 12 eingeschoben ist (vgl. Fig. 2).

Die Greifereinrichtung ist in Längsrichtung hin und her fahrbar in der Anlage gehalten (nicht dargestellt). Sie weist ein Gehäuse 13 auf, in dem ein Klemmwinkel 14 an einer im Scheitel des Klemmwinkels 14 liegenden Achse 15 drehbar gehalten ist. Der Klemmschenkel 16 liegt mit dem Ende 17 auf einer Auflage 18 für die Druckplatte 1 mit dem Eigengewicht des Klemmwinkels 14 auf.

In Richtung Druckplattenende ist an der Auflage 18 eine nach unten gerichtete Einführschiene 19 vorgesehen. Die Auflage 18 weist vorzugsweise die gleiche Neigung auf wie das zu greifende Ende der angehobenen Druckplatte 1. Der Klemmschenkel 16 und die Auflage 18 bilden bereits, bevor die Druckplatte 1 eingeschoben wird, in Richtung der einzuführenden Druckplatte einen Winkel $\beta$ kleiner als 90°. Dadurch wird ein leichtes Einführen der Druckplatte gewährleistet. Am anderen Ende 20 des Klemmwinkels 14 ist ein seitlich herausstehender Bolzen 21 angebracht. An der Stelle, an der die Druckplatte 1 wieder aus der Greifereinrichtung 12 freigegeben werden soll, ist eine Auflaufschräge 22 für den Bolzen 21 des Klemmwinkels 14 vorgesehen.

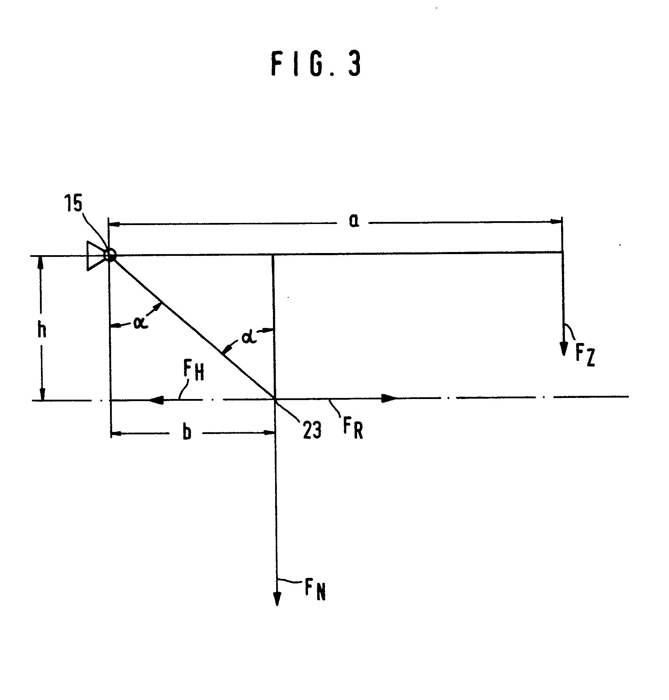

Wenn das Druckplattenende in die Greifereinrichtung 12 eingeschoben ist, bilden Klemmschenkel 16 und Druckplatte 1 einen Winkel von 90° − $\alpha$. Dieser Winkel ist etwas kleiner als der zuvor genannte Winkel $\beta$ zwischen Klemmschenkel 16 und Auflage 18, da die Druckplatte eine bestimmte Dicke hat und den Klemmwinkel 14 um einen von der Dicke abhängigen Betrag entgegen dem Uhrzeigersinn beim Einschieben um die Achse 15 dreht. Für eine gute Klemmwirkung ist es günstig, den Winkel $\alpha$ so klein wie möglich zu wählen. Beim Einsetzen der Bewegung der Greifereinrichtung 12 in Transportrichtung tritt zunächst eine Relativbewegung zwischen Druckplatte 1 und Greifereinrichtung 12 auf, bis der Klemmschenkel 16 um einen kleinen Betrag im Uhrzeigersinn gedreht ist und die Klemmstellung erreicht hat. Für diese Phase bis zum Erreichen der Klemmstellung muss eine ausreichende Reibungskraft vorhanden sein, die die Druckplatte daran hindert, aus der Greifereinrichtung 12 zu rutschen. Diese Reibungskraft ist umso grösser, je grösser der Reibungskoeffizient $\mu$ ist. Der Winkel $\alpha$ soll gleich oder kleiner dem Grenzwinkel $\alpha_o$ sein, der unter Bezugnahme auf Fig. 3 abgeleitet wird.

In Fig. 3 bedeutet 23 den Berührungspunkt der Druckplatte 1 und des Endes 17 des Klemmschenkels 16. Mit $F_Z$ ist die Kraft bezeichnet, die durch das Gewicht des Klemmwinkels gegeben ist. $F_N$ ist die Kraft, die im Berührungspunkt 23 auf die Druckplatte durch den Klemmschenkel wirkt. $F_H$ ist die Haltekraft, die durch die vom Eigengewicht der Druckplatte abhängige Kraft $F_D$ (nicht eingezeichnet) und den Reibungskoeffizienten gegeben ist und entgegen der Reibungskraft $F_R$ wirkt, die wiederum vom Reibungskoeffizienten und $F_N$ abhängt.

$$F_H = F_D \cdot \mu \quad (1)$$

$$F_R = F_N \cdot \mu \quad (2)$$

Damit die Druckplatte am Herausrutschen aus der Greifereinrichtung 12 gehindert wird, bis die Druckplatte zwischen Klemmschenkel 16 und Auflage 18 eingeklemmt ist, muss

$$F_R \geq F_H$$

sein.

Aus Fig. 3 können folgende Beziehungen abgeleitet werden:

$$F_Z \cdot a = F_N \cdot b \quad (3)$$

$$b = h \cdot \tan \alpha \quad (4)$$

Setzt man die Gleichungen (4) und (2) in Gleichung (3) ein, so ergibt sich:

$$F_Z \cdot a = \frac{F_R}{\mu} \cdot h \cdot \tan \alpha \quad (5)$$

Daraus folgt für den Grenzwinkel $\alpha_o$

$$\tan \alpha_o = \frac{F_Z \cdot a}{F_R \cdot h} \cdot \mu \quad (6),$$

wobei

$$\frac{F_Z \cdot a}{h}$$

für den Grenzwinkel $\alpha_o$ einen bestimmten Wert hat, der mit C bezeichnet wird.

Somit ergibt sich

$$\tan \alpha_o = \frac{C}{F_R} \cdot \mu \quad (7)$$

Bei einem bekannten Reibungskoeffizienten $\mu$ ist somit

$$\tan \alpha_o = \frac{C}{F_R} \cdot \mu \quad (8)$$

oder

$$F_R = \frac{C \cdot \mu}{\tan \alpha_o}$$

Die Reibungskraft nimmt also zu, wenn $\alpha$ kleiner als $\alpha_o$ gewählt wird.

Die zwischen Auflage 18 und Klemmschenkel 16 eingeklemmte Druckplatte 1 wird mit der Greifereinrichtung 12 in Transportrichtung gezogen, bis der Bolzen 21 am Klemmwinkel 14 auf die Auflaufschräge 22 läuft. Der Bolzen 21 wird durch die Auflaufschräge 22 angehoben, wodurch der Klemmwinkel 14 um die Achse 15 entgegen dem Uhrzeigersinn gedreht wird. Dadurch öffnet sich die Greifereinrichtung 12, und die Druckplatte 1 rutscht, während die Greifereinrichtung 12 weiter die Auflaufschräge 22 hoch bewegt wird, aus der Greifereinrichtung.

## Patentansprüche

1. Vorrichtung zum Anheben, Greifen und Transportieren von Druckplatten in einem Verarbeitungsgerät, in dem Druckplatten in der jeweiligen Verarbeitungsstation während der Verarbeitung in angesaugter Stellung auf einem Verarbeitungstisch gehalten werden, mit einer unterhalb des Verarbeitungstisches angeordneten, fest mit dem Verarbeitungstisch verbundenen Anhebeeinrichtung für die Druckplatten, die an ihrem oberen Ende mindestens einen Bolzen aufweist, dadurch gekennzeichnet, dass sich oberhalb des Verarbeitungstisches eine in Längsrichtung des Geräts hin und her fahrbare Greifereinrichtung befindet, die die angehobene Druckplatte greift und weitertransportiert, dass der Verarbeitungstisch (2) zusammen mit der Anhebeeinrichtung (3) in Längsrichtung des Geräts verschiebbar ist, dass für die Anhebeeinrichtung (3) eine in Transportrichtung der Druckplatte (1) schräg ansteigende Lauffläche (11) vorgesehen ist, deren Abstand zur auf dem Verarbeitungstisch (2) angesaugten Druckplatte (1) am Beginn (A) der Steigung grösser und am Ende (B) der Steigung kleiner ist als die Höhe (h) der Anhebeeinrichtung (3) im freien Zustand, und dass mindestens der eine Bolzen (7) bei auf ihn ausgeübtem Druck in die Anhebeeinrichtung (3) hinein verschiebbar ist und dabei mindestens eine Feder (5) in der Anhebeeinrichtung (3) vorspannt, deren Federkraft zum Anheben der Druckplatte (1) ausreicht, wenn der Verarbeitungstisch (2) belüftet ist, jedoch nicht ausreicht, die auf dem Verarbeitungstisch (2) angesaugte Druckplatte (1) durch den Bolzen (7) zu beschädigen.

2. Vorrichtung nach Anspruch 1, dadurch gekennzeichnet, dass die Anhebeeinrichtung (3) eine parallel zur Druckplattenbreite verlaufende Schiene (9) aufweist, auf der zwei Bolzen (7) befestigt sind, und die gegen die Feder (5) verschiebbar ist, wenn auf die Bolzen (7) Druck ausgeübt wird.

3. Vorrichtung nach Anspruch 1, dadurch gekennzeichnet, dass die Greifereinrichtung (12) eine Auflage (18) für die Druckplatte (1) sowie einen Klemmwinkel (14) aufweist, der an einer in seinem Scheitel liegenden Achse (15) drehbar gehalten ist, dass das eine Ende (17) des Klemmwinkels (14) auf der Auflage (18) so aufliegt, dass der Klemmschenkel (16) des Klemmwinkels (14) und die Auflage (18) in Richtung der einzuführenden Druckplatte (1) einen Winkel β kleiner als 90° bilden, der Klemmschenkel (16) mit der eingeschobenen Druckplatte einen Winkel von 90° − α bildet, wobei α kleiner oder höchstens gleich einem Grenzwinkel α$_o$ ist, bei dem das Gewicht des Klemmwinkels (14) gerade noch eine genügende Normalkraft (F$_N$) auf die Druckplatte (1) in ihrem Berührungspunkt (23) mit dem Klemmschenkel (16) und damit eine genügende Reibungskraft (F$_R$) hervorruft, um die Druckplatte bei der Bewegung der Greifereinrichtung mitzunehmen, und dass eine Auflaufschräge (22) zum Anheben des anderen Endes (20) des Klemmwinkels (14) in der Bewegungsbahn der Greifereinrichtung (12) an der Stelle angeordnet ist, an der die Druckplatte (1) freigegeben werden soll.

4. Vorrichtung nach Anspruch 3, dadurch gekennzeichnet, dass die Auflage (18) für die Druckplatte (1) die gleiche Neigung aufweist wie das zu greifende Ende der angehobenen Druckplatte.

5. Vorrichtung nach Anspruch 4, dadurch gekennzeichnet, dass die Auflage (18) für die Druckplatte (1) in Richtung der zu greifenden Druckplatte eine nach unten gerichtete Einführschiene (19) aufweist.

6. Vorrichtung nach einem der Ansprüche 3 bis 5, dadurch gekennzeichnet, dass der Klemmwinkel (14) an seinem von der Auflaufschräge anzuhebenden Ende (20) einen Bolzen (21) aufweist, der mit der Auflaufschräge (22) in Eingriff kommt.

**Claims**

1. A device for lifting, gripping and transporting printing plates in a processing apparatus in which, during the processing in the individual stations, the printing plates are fixed by suction on a processing table, which comprises a lifting device for the printing plates which is installed below the processing table and is fixed with the processing table, said lifting device is provided with at least one pin on its upper end, characterized in that a gripping device is installed above the processing table and can be moved to and fro in the longitudinal direction of the apparatus and by which the lifted printing plate is taken up and transported onwardly, in that the processing table (2) with the lifting device (3) together is movable in longitudinal direction of said device, in that a sliding surface (11), rising in the direction of transport of the printing plate (1), is provided for the lifting device (3), whereby at the beginning (A) of the rise the distance between the sliding surface (11) and the printing plate (1) sucked onto the processing table (2) is greater than the height (h) of the lifting device (3), whereas at the upper end (B) of the rise, this distance is smaller than the height (h) of the lifting device (3) in the free state, and in that at the upper end of said lifting device (3), there is at least one pin (7) which slides back into the lifting device (3) when pressure is exerted onto the pin, whereby at least one spring (5) of the lifting device (3) is loaded, the spring tension of which is sufficient to lift the printing plate (1), when the processing table (2) is aerated, but is not sufficient to damage the printing plate (1) sucked onto the processing table (2) by the pin (7).

2. A device as claimed in Claim 1, wherein the lifting device (3) is provided with a rail (9) which runs parallel to the width of the printing plate and on which two pins (7) are installed and which moves against the spring when pressure is exerted onto the pins (7).

3. A device as claimed in Claim 1, characterized in that the gripping device (12) is provided with a support (18) for the printing plate (1) and a clamping angle (14), the clamping angle (14) being pivoted in an axle (15) located at its vertex, in that one end (17) of the clamping angle (14) rests on the support (18), in such a way that, in the direction of the printing plate (1) to be inserted, an angle β of less than 90° is formed by the clamping leg (16) of the clamping angle (14) and the support (18), in that an angle of 90° − α is formed by the clamping leg (16) and the inserted printing plate (1), where-

by α is smaller or at most equal to a critical angle $\alpha_o$, at which angle $\alpha_o$ the weight of the clamping angle (14) yet exerts a sufficient normal force ($F_N$) onto the printing plate (1) at its contact point (23) with the clamping leg (16) and also a sufficient frictional force ($F_R$) to take along the printing plate by the movement of the gripping device, and in that a bevelled leading surface (22) for lifting the other end (20) of the clamping angle (14) is installed in the path of motion of the gripping device (12), at the point where the printing plate (1) is to be released.

4. A device as claimed in Claim 3, wherein the support (18) for the printing plate (1) has the same inclination as the end to be gripped of the lifted printing plate (1).

5. A device as claimed in Claim 4, wherein, in the direction of the printing plate (1) to be gripped, the support (18) for the printing plate (1) is provided with a guide rail (19) being inclined downwardly.

6. A device as claimed in any of Claims 3 to 5, wherein, at the end (20) to be lifted by the bevelled leading surface (22), the clamping angle (14) is equipped with a pin (21) meshing with the bevelled leading surface (22).

## Revendications

1. Installation permettant de soulever, saisir et transporter des plaques d'impression dans un appareil de traitement dans lequel de telles plaques d'impression sont maintenues à chaque poste de traitement et au cours de l'ensemble du traitement, dans une position de maintien par aspiration sur une table de traitement, avec un mécanisme de soulèvement des plaques d'impression qui est disposé au-dessous de cette table, est rendu solidaire à demeure de la table et comporte à son extrémité supérieure au moins un doigt-poussoir, caractérisée en ce que, au-dessus de la table de traitement, se trouve un mécanisme de préhension qui peut se déplacer en va-et-vient suivant la direction longitudinale de l'appareil et qui saisit et transporte plus loin la plaque d'impression soulevée, en ce que la table de traitement (2) est déplaçable en même temps que le mécanisme de soulèvement (3) suivant la direction longitudinale de l'appareil, en ce qu'il est prévu pour ce mécanisme de soulèvement (3) une surface de roulement (11) qui s'élève de manière inclinée suivant la direction de transport de la plaque d'impression (1) et dont l'écartement par rapport à la plaque (1) qui est maintenue par aspiration sur la table de traitement (2) est au début (A) de l'élévation plus grand, et à la fin (B) de l'élévation plus faible, que la hauteur (h) du mécanisme de soulèvement (3) à l'état libre, et en ce qu'au moins ledit doigt-poussoir (7) peut se déplacer dans le mécanisme de soulèvement (3) sous l'effet d'une pression exercée sur lui et met de la sorte sous tension dans ce mécanisme de soulèvement (3) un ressort (5) dont l'effort est suffisant pour soulever la plaque d'impression (1) lorsque la table de traitement (2) est libérée de la mise sous vide, mais ne suffit pas pour que la plaque d'impression (1) qui est maintenue par aspiration sur la table de traitement (2) soit endommagée par le doigt-poussoir (7).

2. Installation selon la revendication 1, caractérisée en ce que le mécanisme de soulèvement (3) comprend une coulisse (9) qui s'étend parallèlement à la largeur de la plaque d'impression et sur laquelle sont fixés deux doigts-poussoirs (7), cette coulisse pouvant être déplacée à l'encontre du ressort (5) lorsqu'une pression est exercée sur ces doigts-poussoirs (7).

3. Installation selon la revendication 1, caractérisée en ce que le mécanisme de préhension (12) comprend un appui (18) pour la plaque d'impression (1), ainsi qu'une cornière de serrage (14) qui est maintenue de manière à pouvoir tourner suivant un axe (15) qui est situé à son sommet, en ce qu'une extrémité (17) de la cornière de serrage (14) repose sur l'appui (18) de manière que l'aile de serrage (16) de la cornière (14) et l'appui (18) forment en direction de la plaque d'impression (1) à introduire, un angle β plus petit que 90°, l'aile de serrage (16) forme avec la plaque d'impression introduite un angle de 90° − α, α étant plus petit ou au plus égal à un angle limite $\alpha_o$, où le poids de la cornière de serrage (14) fournit une force normale suffisante ($F_N$) sur la plaque d'impression (1) au niveau de son point de contact (23) avec l'aile de serrage (16), et donc une force de frottement suffisante ($F_R$) pour que la plaque d'impression soit entraînée lors du mouvement du mécanisme de préhension, et en ce qu'il est prévu, sur le trajet du mécanisme de préhension (12) et à l'emplacement où la plaque d'impression (1) doit être libérée, une rampe de soulèvement (22) destinée à relever l'autre extrémité (20) de la cornière de serrage (14).

4. Installation selon la revendication 3, caractérisée en ce que l'appui (18) prévu pour la plaque d'impression (1) présente la même inclinaison que l'extrémité à saisir de la plaque d'impression soulevée.

5. Installation selon la revendication 4, caractérisée en ce que l'appui (18) prévu pour la plaque d'impression (1) comporte en direction de la plaque d'impression à saisir un rail d'introduction (19) orienté vers le bas.

6. Installation selon l'une des revendications 3 à 5, caractérisée en ce que la cornière de serrage (14) présente à son extrémité (20) qui doit être soulevée par la rampe de relèvement, un axe (21) qui vient en prise avec cette rampe (22).

# FIG.1

0 047 458

FIG. 2

0 047 458

# FIG. 3